# EUROPEAN PATENT SPECIFICATION

(11) **EP 4 215 651 B1**
(45) Date of publication and mention of the grant of the patent: **15.04.2026**
(21) Application number: 20954146.5
(22) Date of filing: 18.09.2020
(51) Int. Cl.: C30B 29/04, H01L 23/373, C30B 28/14

(54) **METHOD FOR MANUFACTURING A SEMICONDUCTOR DEVICE**
VERFAHREN ZUR HERSTELLUNG EINER HALBLEITEREINHEIT
PROCÉDÉ DE FABRICATION D'UN DISPOSITIF SEMI-CONDUCTEUR

(43) Date of publication of application: 26.07.2023
(73) Proprietor: MITSUBISHI ELECTRIC CORPORATION, Chiyoda-ku Tokyo 100-8310 (JP)
(72) Inventor: IMAMURA, Ken, Tokyo 100-8310 (JP); FUJIKAWA, Masahiro, Tokyo 100-8310 (JP); NISHIMURA, Kunihiko, Tokyo 100-8310 (JP); YAGYU, Eiji, Tokyo 100-8310 (JP)
(74) Representative: Meissner Bolte Partnerschaft mbB
(86) International application number: PCT/JP2020/035423
(87) International publication number: WO 2022/059161

(56) References cited:
- JP-A- 2007 284 285
- JP-A- 2007 284 285
- JP-A- 2018 120 963
- JP-A- 2019 519 111
- JP-A- H0 585 892
- JP-A- H06 316 492
- JP-A- H11 157 990

## Description

### TECHNICAL FIELD

The present invention relates to a method for manufacturing a semiconductor device.

### BACKGROUND ART

Diamond having the highest thermal conductivity among solid materials is suitably used as a heat spreader for high-power electronic devices. Particularly, polycrystalline diamond can be fabricated with an area larger than that of single crystal diamond, and is superior in terms of cost.

When polycrystalline diamond is synthesized on an underlying substrate in chemical vapor deposition (CVD), the resulting substrate is warped. A free-standing substrate obtained by removing the underlying substrate from the resulting substrate is more noticeably warped.

When a polycrystalline diamond substrate is used as a heat spreader, the polycrystalline diamond substrate is bonded to a semiconductor device through a bonding process. When warpage of the polycrystalline diamond substrate is large, for example, when the warpage has a of curvature smaller than or equal to 1 m, adhesion properties of a bonded portion become worse. Thus, the polycrystalline diamond substrate cannot be bonded to the semiconductor device, or the bonding strength significantly decreases.

A semiconductor laminated structure disclosed in Patent Document 1 includes: a polycrystalline diamond substrate having first and second principal surfaces; and at least one semiconductor layer disposed on the first principal surface of the polycrystalline diamond substrate. A ratio of the larger of average grain diameters of the first and second principal surfaces of the polycrystalline diamond substrate to the smaller average grain diameter is smaller than or equal to 10. This inhibits warpage. The semiconductor laminated structure is dry etched or polished to make the ratio of the larger average grain diameter to the smaller average grain diameter of the first and second principal surfaces smaller than or equal to 10.
JP2007284285A relates to a highly oriented diamond film whose crystal orientation is highly oriented in the (100) or (111) direction and a method for producing the same.

### PRIOR-ART DOCUMENT

### PATENT DOCUMENT

Patent Document 1: Japanese Patent Application Laid-Open JP 2018-049868 A

### SUMMARY

### PROBLEMS TO BE SOLVED BY THE INVENTION

In the semiconductor laminated structure disclosed in Patent Document 1, however, the dry etching or the polishing to make the ratio of the larger average grain diameter to the smaller average grain diameter of the first and second principal surfaces smaller than or equal to 10 requires a larger removal amount, and takes a long time for the removal. This increases the cost for inhibiting warpage of the polycrystalline diamond substrate.

The present invention solves such a problem, and has an object of providing a polycrystalline diamond substrate whose cost for inhibiting warpage can be reduced, a semiconductor device including the polycrystalline diamond substrate, a method for manufacturing a polycrystalline diamond substrate whose cost for inhibiting warpage can be reduced, and a method for manufacturing a semiconductor device using the method for manufacturing the polycrystalline diamond substrate.

### MEANS TO SOLVE THE PROBLEMS

According to the invention, the problem is solved by the subject matter outlined in independent claim 1. Advantageous further developments of the invention are set forth in the dependent claims.

### EFFECTS OF THE INVENTION

The polycrystalline diamond substrate according to the present invention can reduce the cost for inhibiting warpage.

The semiconductor device according to the present invention is a semiconductor device including the polycrystalline diamond substrate whose cost for inhibiting warpage can be reduced.

The method for manufacturing the polycrystalline diamond substrate according to the present invention can reduce the cost for inhibiting warpage.

The method for manufacturing the semiconductor device according to the present invention is a method for manufacturing a semiconductor device using the method for manufacturing the polycrystalline diamond substrate according to the present invention.

The object, features, aspects and advantages related to the technology disclosed in the DESCRIPTION will become more apparent from the following detailed description and the accompanying drawings.

### BRIEF DESCRIPTION OF THE DRAWINGS

FIG. 1 is a schematic cross-sectional view of a polycrystalline diamond substrate according to Embodiment 1.
FIG. 2 is a schematic cross-sectional view illustrating a state of the polycrystalline diamond substrate during manufacture according to Embodiment 1.
FIG. 3 is a schematic cross-sectional view illustrating stresses applied to polycrystalline diamond layers.
FIG. 4 is a schematic cross-sectional view illustrating a state of the polycrystalline diamond substrate during manufacture according to Embodiment 1.
FIG. 5 is a schematic cross-sectional view of a polycrystalline diamond substrate according to Embodiment 2.
FIG. 6 is a schematic cross-sectional view of a semiconductor device according to Embodiment 3.
FIG. 7 is a schematic cross-sectional view of a semiconductor device according to Embodiment 3.
FIG. 8 is a schematic cross-sectional view illustrating a state of a semiconductor device during manufacture according to Embodiment 4.
FIG. 9 is a schematic cross-sectional view illustrating a state of the semiconductor device during manufacture according to Embodiment 4.
FIG. 10 is a schematic cross-sectional view of the semiconductor device according to Embodiment 4.
FIG. 11 illustrates how to obtain a radius of curvature.

### DESCRIPTION OF EMBODIMENTS

The following Embodiments 1-3 are not according to the invention and are present for illustration purpose only.

### [A. Embodiment 1]

### [A-1. Structure]

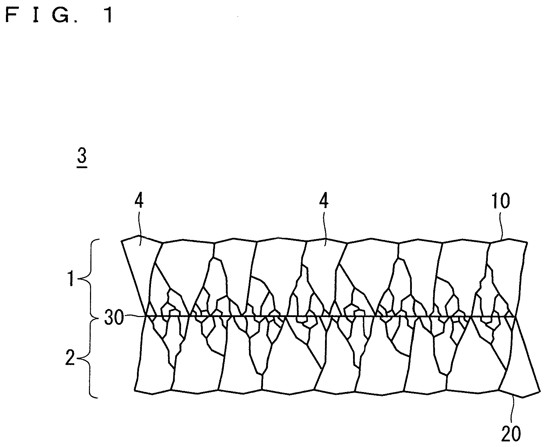

FIG. 1 is a cross-sectional view of a polycrystalline diamond substrate 3 according to Embodiment 1. The polycrystalline diamond substrate 3 includes a first polycrystalline diamond layer 1 and a second polycrystalline diamond layer 2. The first polycrystalline diamond layer 1 is connected to the second polycrystalline diamond layer 2 through an intermediate surface 30. The first polycrystalline diamond layer 1 has a surface opposite to the second polycrystalline diamond layer 2 as a first principal surface 10. The second polycrystalline diamond layer 2 has a surface opposite to the first polycrystalline diamond layer 1 as a second principal surface 20. The first polycrystalline diamond layer 1 and the second polycrystalline diamond layer 2 are diamond polycrystals, and each include a plurality of diamond crystal grains 4.

It is known that a polycrystalline diamond fabricated in CVD has a columnar grain structure and has grain diameters increasing from a growth initial layer to a growth plane. Grain diameters of the first principal surface 10 and the second principal surface 20 are larger than those of the intermediate surface 30 in the polycrystalline diamond substrate 3 according to Embodiment 1. In other words, a surface whose average grain diameter is smaller than those of the first principal surface 10 and the second principal surface 20 exists between the first principal surface 10 and the second principal surface 20.

Furthermore, the grain diameters increase from the intermediate surface 30 to the first principal surface 10 and to the second principal surface 20. In other words, the first principal surface 10 and the second principal surface 20 are growth planes of polycrystalline diamond. The intermediate surface 30 can be identified as a surface whose average grain diameter is the smallest in a thickness direction, in the polycrystalline diamond substrate 3.

Furthermore, the first polycrystalline diamond layer 1 is a region between the intermediate surface 30 and the first principal surface 10 that is one of the principal surfaces of the polycrystalline diamond substrate 3. The second polycrystalline diamond layer 2 is a region between the intermediate surface 30 and the second principal surface 20 that is the other principal surface of the polycrystalline diamond substrate 3.

An average grain diameter in a surface is obtained by observing a cross section as illustrated in FIG. 1 through a scanning electron microscope (SEM), drawing a line segment in a surface direction, and determining an average of lengths that the line segment crosses respective grains, as the average grain diameter. Here, an endpoint of the line segment and a boundary of the grains are butted together. The drawn line segment is as long as 20 or more grains appearing on the line segment.

### [A-2. Manufacturing method]

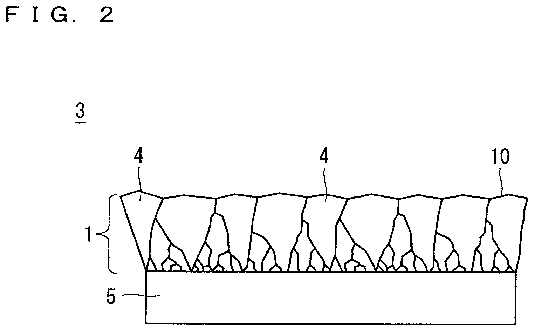

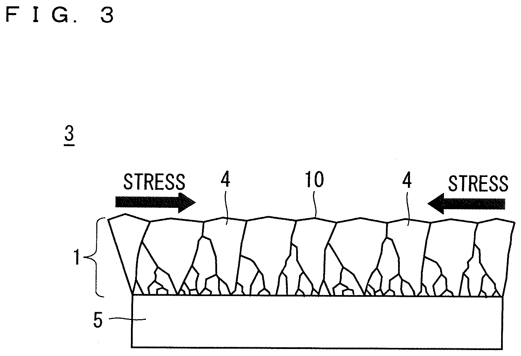

A method for manufacturing a polycrystalline diamond substrate according to Embodiment 1 that is a method for manufacturing the polycrystalline diamond substrate 3 will be described with reference to FIGS. 2 to 4.

First, an underlying substrate 5 was prepared.

Examples of a material of the underlying substrate 5 can include silicon, silicon nitride, aluminum nitride, silicon carbide, molybdenum, and tungsten. It is preferred in forming polycrystalline diamond to perform, in advance, a process for promoting the initial nucleation that is a starting point for forming the polycrystalline diamond.

Examples of the process for promoting the initial nucleation include forming irregularities on a surface of a substrate for growth through blasting, and applying diamond minute particles in dispersion form on the surface of the underlying substrate 5. In Embodiment 1, the underlying substrate 5 was made of silicon. The underlying substrate 5 was ultrasonicated in dispersions of nanodiamond whose grain diameter was 2 to 5 nm to apply diamond minute particles in dispersion form on the surface of the underlying substrate 5.

Next, the first polycrystalline diamond layer 1 was formed on the underlying substrate 5 as illustrated in FIG. 2.

The first polycrystalline diamond layer 1 is formed in CVD. Microwave CVD with a higher deposition rate and better long-time discharge stability is suitably used. A source gas is a mixed gas containing methane (CH₄), hydrogen (H₂), and oxygen (O₂). When the semiconductor conductivity of the first polycrystalline diamond layer 1 is controlled as p-type, diborane (B₂H₆) that is a boron compound is added to the source gas.

When the semiconductor conductivity of the first polycrystalline diamond layer 1 is controlled as n-type, phosphine (PH₃) that is a phosphorus compound is added to the source gas. An inert gas such as argon (Ar) may be added to the source gas to improve the crystal quality and increase a crystal formation rate.

In Embodiment 1, the first polycrystalline diamond layer 1 was formed under conditions in Table 1 in CVD.

**[Table 1]**

| | |
|---|---|
| MICROWAVE FREQUENCY | 2. 45 GHz |
| MICROWAVE POWER | 5 kW |
| PRESSURE | 133 hPa |
| H₂ GAS FLOW RATE | 478 sccm |
| CH₄ GAS FLOW RATE | 20 sccm |
| O₂ GAS FLOW RATE | 2 sccm |
| SUBSTRATE TEMPERATURE | 900 °C |
| GROWTH TIME | 50 hours |

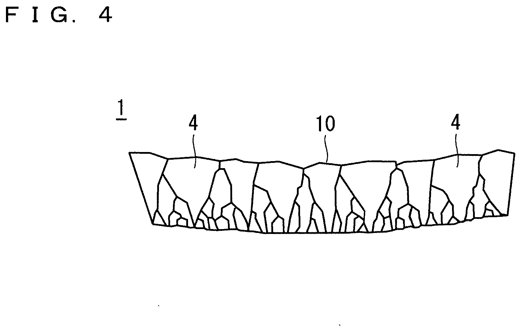

Then, the underlying substrate 5 was removed from the first polycrystalline diamond layer 1. The underlying substrate 5 can be removed by, for example, wet etching, grinding, laser beam machining, or dry etching. The underlying substrate 5 was wet etched using a mixed solution of hydrofluoric acid and nitric acid in Embodiment 1. As described above, the first polycrystalline diamond layer 1 was obtained as a free-standing substrate as illustrated in FIG. 4.

The first polycrystalline diamond layer 1 had a thickness of 100 µm, and its synthetic rate was 2 µm/h. The measurement of warpage of the first polycrystalline diamond layer 1 through a profilometer showed that the warpage had 1 m of a radius of curvature. The observation of a cross section of the first polycrystalline diamond layer 1 through a scanning electron microscope (SEM) showed that a surface on which the underlying substrate 5 used to be formed had an average grain diameter of 0.05 µm and a growth plane had an average grain diameter of 20 µm.

The radiuses of curvature of the first polycrystalline diamond layer 1 and the second polycrystalline diamond layer 2 are calculated based on surface profiles of the first principal surface 10 and the second principal surface 20, respectively. The profile of the first principal surface 10 or the second principal surface 20 is measured on a straight line that passes through the center of the first principal surface 10 or the second principal surface 20 in a plan view.

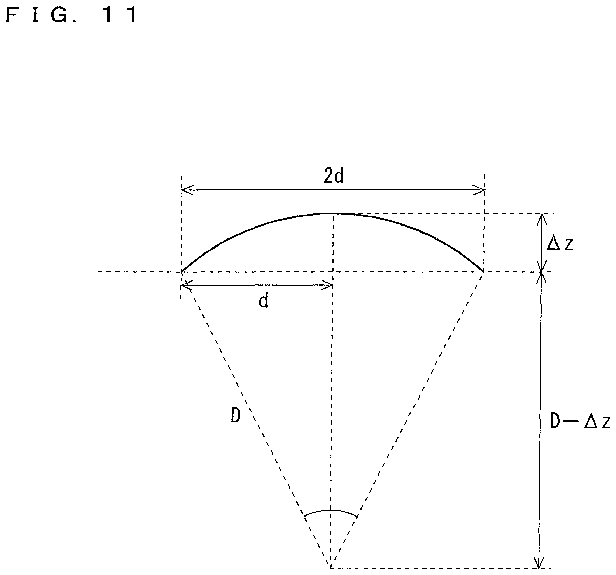

Assuming that D denotes a radius of curvature of the first polycrystalline diamond layer 1 or the second polycrystalline diamond layer 2 on the straight line, d denotes the radius, and Δz denotes a height difference in the measured surface profile, the radius of curvature D is calculated by (d² + Δz²)/(2Δz) (FIG. 11). The radius of curvature on the surface profile of the first principal surface 10 or the second principal surface 20 is measured on each of the four straight lines rotated in increments of 45° in a surface, and is obtained as the smallest value among the radiuses of curvature on the four straight lines. The radius of curvature of the polycrystalline diamond substrate 3 is a larger one of the radiuses of curvature of the first principal surface 10 and the second principal surface 20.

The surface profile of the first principal surface 10 or the second principal surface 20 can be measured through a stylus profilometer or an optical profilometer. The profile on the straight line that passes through the center of the first principal surface 10 or the second principal surface 20 in a plan view is measured at 100 points or more at equal intervals.

Next, the second polycrystalline diamond layer 2 was formed in CVD on a back side of the first principal surface 10 of the first polycrystalline diamond layer 1, that is, on a surface on which the underlying substrate 5 used to be formed. The back side of the first principal surface 10 on which the second polycrystalline diamond layer 2 was formed corresponds to the intermediate surface 30.

As described above, the polycrystalline diamond substrate 3 according to Embodiment 1 was obtained as illustrated in FIG. 1. The polycrystalline diamond substrate 3 had a thickness of 200 µm. The measurement of warpage of the polycrystalline diamond substrate 3 showed that the radius of curvature was 5 m.

For comparison, a polycrystalline diamond layer was formed on the underlying substrate 5 under the conditions in Table 1 except the growth time which was adjusted so that the thickness of the polycrystalline diamond layer became 200 µm. The measurement of warpage of the polycrystalline diamond layer from which the underlying substrate 5 was removed showed that the radius of curvature was 0.7 m.

The observation of a cross section of the polycrystalline diamond substrate 3 according to Embodiment 1 through the SEM showed that an average grain diameter of the intermediate surface 30 was 0.05 µm, an average grain diameter of the first principal surface 10 was 20 µm, and an average grain diameter of the second principal surface 20 was 19 µm.

The method for manufacturing the polycrystalline diamond substrate according to Embodiment 1 creates the polycrystalline diamond substrate 3 with the average grain diameter of the intermediate surface 30 smaller than that of each of the first principal surface 10 and the second principal surface 20. In the method for manufacturing the polycrystalline diamond substrate according to Embodiment 1, the warpage of the polycrystalline diamond substrate 3 is inhibited even when a surface whose average grain diameter is smaller than or equal to 1/10 of that of each of the first principal surface 10 and the second principal surface 20 exists between the first principal surface 10 and the second principal surface 20, that is, even when the back side of the first principal surface 10 is not shaved through, for example, dry etching or polishing.

In Embodiment 1, the smaller of the average grain diameter (D1) of the first principal surface 10 and the average grain diameter (D2) of the second principal surface 20 is preferably more than or equal to 0.7 times the larger one. More preferably, the smaller of the two average grain diameters is more than or equal to 0.9 times the larger one. When D1/D2 is closer to 1, a relationship between stress and warpage dependent on a crystalline structure of a polycrystalline diamond in the first polycrystalline diamond layer 1 can be approximated to that in the second polycrystalline diamond layer 2.

Thus, making D1/D2 closer to 1 in Embodiment 1 enables the relationship between stress and warpage in the first polycrystalline diamond layer 1 to be approximated to that in the second polycrystalline diamond layer 2. This can effectively inhibit warpage. For example, the radius of curvature of the polycrystalline diamond substrate 3 can be larger than or equal to 1 m.

The relationship between stress and warpage in each of the first polycrystalline diamond layer 1 and the second polycrystalline diamond layer 2 is dependent on a proportion of a non-diamond component. The proportion of the non-diamond component can be confirmed by: measuring respective peak intensities of a diamond component in the vicinity of 1330 cm⁻¹ and a non-diamond component in the vicinity of 1530 cm⁻¹ through Raman spectroscopy of each of the first polycrystalline diamond layer 1 and the second polycrystalline diamond layer 2; and obtaining a ratio of the peak intensity of the non-diamond component to the peak intensity of the diamond component.

To inhibit the warpage of the polycrystalline diamond substrate 3 by approximating the relationships between stress and warpage in the first polycrystalline diamond layer 1 and the second polycrystalline diamond layer 2 as described in Embodiment 1, a ratio R1 = G1/F1 of a peak intensity G1 of the non-diamond component to a peak intensity F1 of the diamond component in the first polycrystalline diamond layer 1 is preferably close to a ratio R2 = G2/F2 of a peak intensity G2 of the non-diamond component to a peak intensity F2 of the diamond component in the second polycrystalline diamond layer 2. For example, the smaller of R1 and R2 is preferably more than or equal to 0.7 times the larger one. More preferably, the smaller of R1 and R2 is more than or equal to 0.9 times the larger one.

As described above, forming the first polycrystalline diamond layer 1 and the second polycrystalline diamond layer 2 under the same conditions in CVD approximates the relationships between stress and warpage in the first polycrystalline diamond layer 1 and the second polycrystalline diamond layer 2. This facilitates setting the conditions on CVD for inhibiting the warpage of the polycrystalline diamond substrate 3. Here, the conditions on CVD with, for example, tolerances of 1% or less in Table 1 when the first polycrystalline diamond layer 1 and the second polycrystalline diamond layer 2 are formed may be regarded as the same conditions.

Growing the second polycrystalline diamond layer 2 from the back side of the first polycrystalline diamond layer 1, that is, the intermediate surface creates equivalent stresses in an opposite direction in the first polycrystalline diamond layer 1 and the second polycrystalline diamond layer 2, and offsets effects of the stresses. In other words, the first polycrystalline diamond layer 1 has a stress that attempts to warp the first polycrystalline diamond layer 1 toward the first principal surface 10 side, and the second polycrystalline diamond layer 2 has a stress that attempts to warp the second polycrystalline diamond layer 2 toward the second principal surface 20 side.

The connection of the first polycrystalline diamond layer 1 to the second polycrystalline diamond layer 2 offsets an effect of the stress of the first polycrystalline diamond layer 1 that attempts to warp the first polycrystalline diamond layer 1 toward the first principal surface 10 side against an effect of the stress of the second polycrystalline diamond layer 2 that attempts to warp the second polycrystalline diamond layer 2 toward the second principal surface 20 side. In the following description, such a state will be referred to a state where warpage of the first polycrystalline diamond layer 1 and the second polycrystalline diamond layer 2 is offset or a state where the warpage of the first polycrystalline diamond layer 1 is offset against that of the second polycrystalline diamond layer 2.

As a result of offsetting the warpage of the first polycrystalline diamond layer 1 against that of the second polycrystalline diamond layer 2, the polycrystalline diamond substrate 3 with inhibited warpage was obtained. Particularly, the radius of curvature of each of the second polycrystalline diamond layer 2 and the first polycrystalline diamond layer 1 after the second polycrystalline diamond layer 2 is formed is larger than that of the first polycrystalline diamond layer 1 after the underlying substrate 5 is removed from the first polycrystalline diamond layer 1 and before the second polycrystalline diamond layer 2 is formed.

The polycrystalline diamond substrate 3 with inhibited warpage can be bonded to a semiconductor device. Mechanically polishing one of or both of the surfaces of this substrate enables this substrate to be used as a substrate for a heat spreader.

In the polycrystalline diamond substrate 3 according to Embodiment 1, the warpage of the first polycrystalline diamond layer 1 is offset against that of the second polycrystalline diamond layer 2. Thus, the warpage of the polycrystalline diamond substrate 3 is inhibited without polishing any of the surfaces. Thus, the amount of polishing for further improving the warpage is less. This can shorten the polishing time, and is applicable to mass production.

Embodiment 1 exemplifies forming the second polycrystalline diamond layer 2 on the back side of the first polycrystalline diamond layer 1 handled alone as a free-standing substrate. When the first polycrystalline diamond layer 1 is thin, the first principal surface 10 of the first polycrystalline diamond layer 1 may be attached to another substrate. Then, the second polycrystalline diamond layer 2 may be formed.

Although the second polycrystalline diamond layer 2 was formed on the back side of the first polycrystalline diamond layer 1 as it was, that is, on the surface on which the underlying substrate 5 used to be formed in Embodiment 1, several µm of the back side of the first polycrystalline diamond layer 1 may be polished off to remove a diamond initial layer. Then, the second polycrystalline diamond layer 2 may be formed on the back side. This can increase the thermal conductivity of the polycrystalline diamond substrate 3.

The conditions on CVD in forming the second polycrystalline diamond layer 2 may be changed according to the stress of the first polycrystalline diamond layer 1 for adjusting the stress of the second polycrystalline diamond layer 2. This can inhibit the warpage of the polycrystalline diamond substrate 3 more.

### [A-3. Advantages]

The polycrystalline diamond substrate 3 is a polycrystalline diamond substrate having the first principal surface 10 and the second principal surface 20, and includes, between the first principal surface 10 and the second principal surface 20, a surface having an average grain diameter smaller than each of average grain diameters of the first principal surface 10 and the second principal surface 20. This can reduce the cost for inhibiting the warpage of the polycrystalline diamond substrate 3.

The first polycrystalline diamond layer 1 has a stress that attempts to warp the first polycrystalline diamond layer 1 toward the first principal surface 10 side, and the second polycrystalline diamond layer 2 has a stress that attempts to warp the second polycrystalline diamond layer 2 toward the second principal surface 20 side. This offsets warpage of the first polycrystalline diamond layer 1 against that of the second polycrystalline diamond layer 2. Thus, the polycrystalline diamond substrate 3 can reduce the cost for inhibiting the warpage.

In the polycrystalline diamond substrate 3, the smaller of an average grain diameter D1 of the first principal surface 10 and an average grain diameter D2 of the second principal surface 20 is preferably more than or equal to 0.7 times the larger of the average grain diameter D1 of the first principal surface 10 and the average grain diameter D2 of the second principal surface 20. Consequently, the relationship between stress and warpage in the first polycrystalline diamond layer 1 can be approximated to that in the second polycrystalline diamond layer 2. Thus, the warpage of the polycrystalline diamond substrate 3 can be further inhibited.

A method for manufacturing a polycrystalline diamond substrate according to Embodiment 1 includes: forming the first polycrystalline diamond layer 1 on the underlying substrate 5 in CVD; removing the underlying substrate 5 from the first polycrystalline diamond layer 1; and forming the second polycrystalline diamond layer 2 on the intermediate surface 30 in CVD, the intermediate surface 30 being a surface on which the underlying substrate 5 of the first polycrystalline diamond layer 1 used to be formed, wherein an average grain diameter of the intermediate surface 30 is smaller than each of average grain diameters of the first principal surface 10 and the second principal surface 20. This method for manufacturing the polycrystalline diamond substrate according to Embodiment 1 can reduce the cost for inhibiting the warpage of the polycrystalline diamond substrate 3.

Forming the first polycrystalline diamond layer 1 and the second polycrystalline diamond layer 2 under the same conditions in CVD facilitates setting the conditions on CVD for inhibiting the warpage of the polycrystalline diamond substrate 3.

### [B. Embodiment 2]

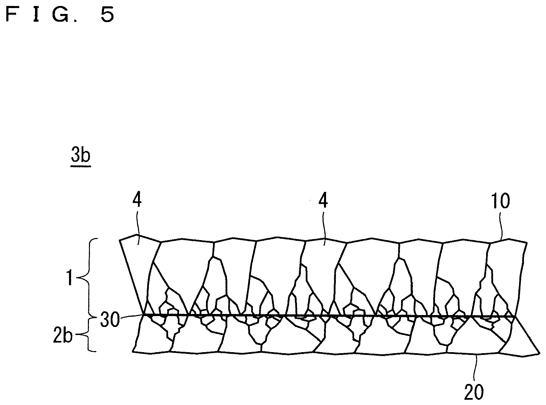

As illustrated in FIG. 5, a polycrystalline diamond substrate 3b according to Embodiment 2 includes a second polycrystalline diamond layer 2b, instead of the second polycrystalline diamond layer 2 in the polycrystalline diamond substrate 3 according to Embodiment 1.

The structure of the polycrystalline diamond substrate 3b is identical to that of the polycrystalline diamond substrate 3 according to Embodiment 1 in the range described in "A-1. Structure" by reading the second polycrystalline diamond layer 2 as the second polycrystalline diamond layer 2b in the description.

### [B-1. Manufacturing method]

A method for manufacturing the polycrystalline diamond substrate according to Embodiment 2 is identical to that according to Embodiment 1 in that the method includes: forming the first polycrystalline diamond layer 1 on the underlying substrate 5 in CVD; removing the underlying substrate 5 from the first polycrystalline diamond layer 1; and forming the second polycrystalline diamond layer 2b on the intermediate surface 30 in CVD, the intermediate surface 30 being a surface on which the underlying substrate 5 of the first polycrystalline diamond layer 1 used to be formed, wherein an average grain diameter of the intermediate surface 30 is smaller than each of average grain diameters of the first principal surface 10 and the second principal surface 20, the first principal surface 10 being a principal surface of the first polycrystalline diamond layer 1 and opposite to the second polycrystalline diamond layer 2b, the second principal surface 20 being a principal surface of the second polycrystalline diamond layer 2b and opposite to the first polycrystalline diamond layer 1.

Although the first polycrystalline diamond layer 1 and the second polycrystalline diamond layer 2 were formed under the same conditions in CVD in Embodiment 1, the second polycrystalline diamond layer 2b was formed under conditions different from those for the first polycrystalline diamond layer 1 in Embodiment 2.

In the method for manufacturing the polycrystalline diamond substrate according to Embodiment 2, processes from forming the first polycrystalline diamond layer 1 on the underlying substrate 5 as illustrated in FIG. 2 up to removing the underlying substrate 5 to obtain the first polycrystalline diamond layer 1 as illustrated in FIG. 4 were performed in the same manner as those for Embodiment 1.

Next, the second polycrystalline diamond layer 2b was formed on a back side of the first polycrystalline diamond layer 1 under conditions indicated in Table 2 in CVD. The concentration of CH₄ gas in the conditions in Table 2 is higher than that in the conditions in Table 1.

**[Table 2]**

| | |
|---|---|
| MICROWAVE FREQUENCY | 2. 45 GHz |
| MICROWAVE POWER | 5 kW |
| PRESSURE | 133 hPa |
| H₂ GAS FLOW RATE | 456 sccm |
| CH₄ GAS FLOW RATE | 40 sccm |
| O₂ GAS FLOW RATE | 4 sccm |
| SUBSTRATE TEMPERATURE | 900 °C |
| GROWTH TIME | 10 hours |

For comparison, a polycrystalline diamond layer was grown on the underlying substrate 5 under the conditions in Table 2. Then, the underlying substrate 5 was removed from the resulting substrate to create a free-standing substrate. The free-standing substrate had a thickness of 50 µm, a synthetic rate of the polycrystalline diamond layer was 5 µm/h, and warpage of the free-standing substrate had a radius of curvature of 0.7 m.

FIG. 5 illustrates the polycrystalline diamond substrate 3b obtained by forming the second polycrystalline diamond layer 2b under the conditions in Table 2.

Respective peak intensities of a diamond component in the vicinity of 1330 cm⁻¹ and a non-diamond component in the vicinity of 1530 cm⁻¹ were measured through Raman spectroscopy of each of the first polycrystalline diamond layer 1 and the second polycrystalline diamond layer 2b in the polycrystalline diamond substrate 3b. A ratio R1 = G1/F1 of a peak intensity G1 of the non-diamond component to a peak intensity F1 of the diamond component in the first polycrystalline diamond layer 1 was 0.03, whereas a ratio R2 = G2/F2 of a peak intensity G2 of the non-diamond component to a peak intensity F2 of the diamond component in the second polycrystalline diamond layer 2b was 0.20.

The measurement of the warpage of the polycrystalline diamond substrate 3b showed that the warpage had a radius of curvature of 3 m. In the method for manufacturing the polycrystalline diamond substrate according to Embodiment 2, in which the conditions for fabricating the second polycrystalline diamond layer 2b are different from those for fabricating the first polycrystalline diamond layer 1, the warpage of the first polycrystalline diamond layer 1 was offset against that of the second polycrystalline diamond layer 2b.

Thus, the polycrystalline diamond substrate 3b with inhibited warpage was obtained. The method for manufacturing the polycrystalline diamond substrate according to Embodiment 2 does not require polishing for inhibiting warpage, or can reduce the amount of polishing for inhibiting the warpage even when the polishing is performed. This can reduce the cost for inhibiting the warpage.

The observation of a cross section of the polycrystalline diamond substrate 3b obtained in the method for manufacturing the polycrystalline diamond substrate according to Embodiment 2 through the SEM showed that an average grain diameter of the intermediate surface 30 was 0.05 µm, an average grain diameter of the first principal surface 10 was 20 µm, and an average grain diameter of the second principal surface 20 was 10 µm.

The warpage of the polycrystalline diamond substrate 3b is inhibited even when a surface whose average grain diameter is smaller than or equal to 1/10 of that of each of the first principal surface 10 and the second principal surface 20 exists between the first principal surface 10 and the second principal surface 20, that is, even when the back side of the first principal surface 10 is not shaved through, for example, dry etching or polishing.

The second polycrystalline diamond layer 2b was fabricated under the conditions including a higher concentration of CH₄ in Embodiment 2. The increase in the concentration of CH₄ increases the synthetic rate. Furthermore, the increase in the concentration of CH₄ introduces a non-diamond component. This increases a change in the stress with respect to an amount of deformation.

The synthetic rate of the second polycrystalline diamond layer 2b in forming the second polycrystalline diamond layer 2b is higher than that of the first polycrystalline diamond layer 1 in forming the first polycrystalline diamond layer 1. This can reduce the synthesis time of the whole polycrystalline diamond substrate 3b.

Meanwhile, as the concentration of CH₄ in CVD is lower, the thermal conductivity of resulting polycrystalline diamond becomes higher. Thus, application of the conditions including a higher concentration of CH₄ only in forming the second polycrystalline diamond layer 2b can reduce the synthesis time of the whole polycrystalline diamond substrate 3b, and reduce a decrease in the thermal conductivity of the polycrystalline diamond substrate 3b.

To reduce the synthesis time of the whole polycrystalline diamond substrate 3b, the conditions other than the concentration of CH₄ may be changed. Furthermore, a relationship between synthetic conditions and stress may be studied in advance, and the stress of the second polycrystalline diamond layer 2b may be adjusted according to the stress of the first polycrystalline diamond layer 1.

To enhance the effect of inhibiting warpage in Embodiment 2, preferably, a ratio of a peak intensity of the non-diamond component to a peak intensity of the diamond component that are measured through Raman spectroscopy in the second polycrystalline diamond layer 2b is higher than that in the first polycrystalline diamond layer 1, that is, R1 < R2, and a ratio (D1/D2) of the average grain diameter D1 of the first principal surface 10 to the average grain diameter D2 of the second principal surface 20 is larger than 1 and smaller than or equal to 10.

When R1 < R2 and D1 > D2 hold, an effect in that the polycrystalline diamond substrate 3b tends to warp toward the second polycrystalline diamond layer 2b side with the larger R2 is offset against an effect in that the polycrystalline diamond substrate 3b tends to warp toward the first polycrystalline diamond layer 1 side with the smaller D2. This offsets the warpage of the first polycrystalline diamond layer 1 against the warpage of the second polycrystalline diamond layer 2b better, and can effectively reduce the warpage of the polycrystalline diamond substrate 3b.

Furthermore, the effect of offsetting the warpage of the first polycrystalline diamond layer 1 against the second polycrystalline diamond layer 2b is never too small with D1/D2 being smaller than or equal to 10. Furthermore, the thermal conductivity of the second polycrystalline diamond layer 2b is never too bad with R1/R2 being larger than or equal to 0.1.

### [B-2. Advantages]

In the polycrystalline diamond substrate 3b, the average grain diameter D1 of the first principal surface 10 is larger than the average grain diameter D2 of the second principal surface 20. Consequently, a condition with which an amount of change in stress with respect to an amount of change in warpage is larger, that is, a condition with which a deposition rate is higher is applicable to the second polycrystalline diamond layer 2b. Thus, the fabrication time can be shortened.

In the polycrystalline diamond substrate 3b, a ratio D1/D2 is preferably smaller than or equal to 10, D1 representing the average grain diameter of the first principal surface 10, D2 representing the average grain diameter of the second principal surface 20. Consequently, the effect of offsetting the warpage of the first polycrystalline diamond layer 1 against the second polycrystalline diamond layer 2b is never too small.

In the polycrystalline diamond substrate 3b, a ratio R1 = G1/F1 of the peak intensity G1 of the non-diamond component to the peak intensity F1 of the diamond component through Raman spectroscopy of the first polycrystalline diamond layer 1 is smaller than a ratio R2 = G2/F2 of the peak intensity G2 of the non-diamond component to the peak intensity F2 of the diamond component through Raman spectroscopy of the second polycrystalline diamond layer 2b.

Consequently, a condition with which an amount of change in stress with respect to an amount of change in warpage is larger, that is, a condition with which a deposition rate is higher is applicable to the second polycrystalline diamond layer 2b. Thus, the fabrication time can be shortened. Furthermore, the thermal conductivity of the second polycrystalline diamond layer 2b is never too bad with R1/R2 being larger than or equal to 0.1.

R1 < R2 and D1 > D2 can effectively reduce the warpage of the polycrystalline diamond substrate 3b.

In the method for manufacturing the polycrystalline diamond substrate according to Embodiment 2, the synthetic rate of the second polycrystalline diamond layer 2b in forming the second polycrystalline diamond layer 2b is higher than that of the first polycrystalline diamond layer 1 in forming the first polycrystalline diamond layer 1. Thus, the synthesis time of the whole polycrystalline diamond substrate 3b can be reduced.

### [C. Embodiment 3]

Embodiment 3 will describe a semiconductor device 50 including the polycrystalline diamond substrate 3 according to Embodiment 1 or the polycrystalline diamond substrate 3b according to Embodiment 2. Although the semiconductor device 50 including the polycrystalline diamond substrate 3 is described below, the polycrystalline diamond substrate 3 may be replaced with the polycrystalline diamond substrate 3b.

### [C-1. Structure]

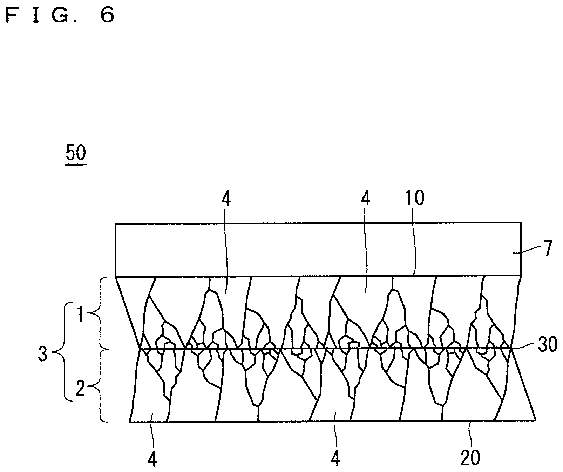

FIG. 6 is a cross-sectional view of the semiconductor device 50.

The semiconductor device 50 includes the polycrystalline diamond substrate 3, and a semiconductor layer 7.

In the semiconductor device 50, the surface of the semiconductor layer 7 is bonded to the first principal surface 10 or the second principal surface 20 of the polycrystalline diamond substrate 3. An example where the surface of the semiconductor layer 7 is bonded to the first principal surface 10 will be described below.

Although there is no restraint on a specific structure of the semiconductor layer 7, bonding the semiconductor layer 7, for example, made of gallium nitride (GaN) appropriate for high-output devices or having a laminated structure of GaN and AlGaN or AlN to the polycrystalline diamond substrate 3 is effective.

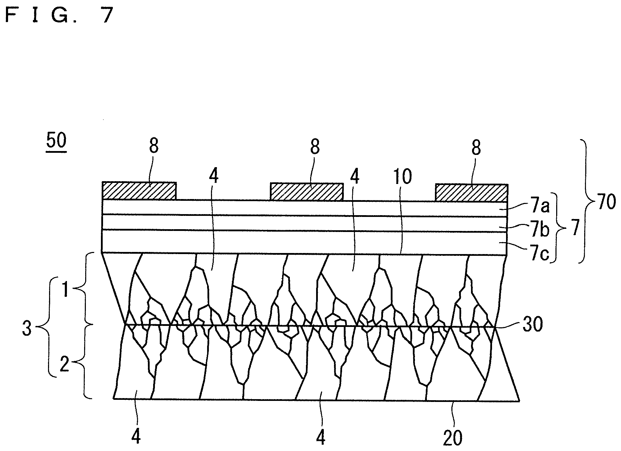

The semiconductor device 50 may include, for example, the polycrystalline diamond substrate 3, and a semiconductor element 70 as illustrated in FIG. 7. Here, the semiconductor element 70 includes the semiconductor layer 7, and the semiconductor layer 7 of the semiconductor element 70 is bonded to the first principal surface 10 or the second principal surface 20 of the polycrystalline diamond substrate 3.

The semiconductor layer 7 has, for example, a semiconductor laminated structure containing GaN. The semiconductor layer 7 includes, for example, a buffer layer 7c (e.g., GaN or AlGaN), a channel layer 7b (e.g., GaN), and a barrier layer 7a (e.g., AlGaN or InAlN) in an order closer to the polycrystalline diamond substrate 3. The surface of the buffer layer 7c, that is, the surface of the semiconductor layer 7 is bonded to the first principal surface 10. Electrodes 8 including a gate electrode and a source electrode are formed on the semiconductor layer 7 in the semiconductor element 70.

### [C-2. Manufacturing method]

In a method for manufacturing the semiconductor device according to Embodiment 3, a material with a surface on which the semiconductor layer 7 is exposed is prepared. Then, the polycrystalline diamond substrate 3 is prepared through the method for manufacturing the polycrystalline diamond substrate 3 according to Embodiment 1. Next, the surface of the semiconductor layer 7 is bonded to the polycrystalline diamond substrate 3 to manufacture the semiconductor device 50.

First, the polycrystalline diamond substrate 3 is manufactured through the method for manufacturing the polycrystalline diamond substrate according to Embodiment 1. Furthermore, the material with the surface on which the semiconductor layer 7 is exposed is prepared. The material with the surface on which the semiconductor layer 7 is exposed is, for example, the semiconductor element 70. Furthermore, the material with the surface on which the semiconductor layer 7 is exposed may be the semiconductor layer 7 itself.

Next, the surface of the semiconductor layer 7 is bonded to the polycrystalline diamond substrate 3. This brings the semiconductor device 50.

A method for bonding the surface of the semiconductor layer 7 to the polycrystalline diamond substrate 3 is preferably a surface activated bonding method or an atomic diffusion bonding method. When the polycrystalline diamond substrate 3 is used as a heat spreader, preferably, no bonding material is applied between the polycrystalline diamond substrate 3 and the semiconductor layer 7. However, as long as the bonding material is approximately several tens of nm in thickness, there is no problem in applying the bonding material. More preferably, the bonding material has a thickness of 10 nm or less.

Furthermore, the semiconductor device 50 according to Embodiment 3 is fabricated by bonding the semiconductor layer 7 to the polycrystalline diamond substrate 3. Before bonding the semiconductor layer 7 to the polycrystalline diamond substrate 3, each bonded surface of the semiconductor layer 7 and the polycrystalline diamond substrate 3 is preferably polished off with an arithmetic average roughness Ra of less than 5 nm of the surface.

Since the polycrystalline diamond substrate 3 according to Embodiment 3 is flat by the offset of warpage of the first polycrystalline diamond layer 1 against warpage of the second polycrystalline diamond layer 2 as described in Embodiment 1, the polycrystalline diamond substrate 3 can be bonded to the semiconductor layer 7. With this structure, the polycrystalline diamond substrate 3 can be used as a heat spreader of the semiconductor layer 7. Furthermore, since the polycrystalline diamond substrate 3 is flat, the semiconductor device 50 can be fabricated with a higher yield rate.

The method for manufacturing the polycrystalline diamond substrate according to Embodiment 1 is applied to the method for manufacturing the semiconductor device according to Embodiment 3. This method for manufacturing the semiconductor device according to Embodiment 3 can reduce the cost for inhibiting warpage of the polycrystalline diamond substrate 3 and the cost for manufacturing the semiconductor device 50.

### [D. Embodiment 4]

Embodiment 4 will describe a method for manufacturing the semiconductor device 50 described in Embodiment 3. The method is different from that in Embodiment 3.

The method for manufacturing the semiconductor device according to Embodiment 4 is identical to that according to Embodiment 3 in preparing a material with a surface on which the semiconductor layer 7 is exposed and performing the method for manufacturing the polycrystalline diamond substrate according to Embodiment 1 or 2. However, in the method for manufacturing the semiconductor device according to Embodiment 4, the surface of the material on which the semiconductor layer 7 is exposed is bonded to the first principal surface of the first polycrystalline diamond layer 1 before the second polycrystalline diamond layer 2 or 2b is formed. This will be described hereinafter in detail.

At first, the first polycrystalline diamond layer 1 was formed as illustrated in FIG. 4 similarly to Embodiment 1.

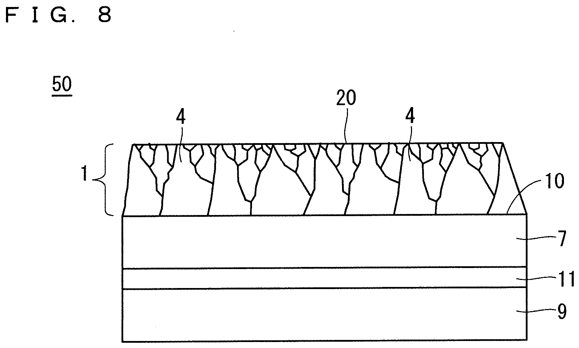

Next, the first principal surface 10 (a polycrystalline diamond growth plane) of the first polycrystalline diamond layer 1 was mechanically polished into a surface with an arithmetic average roughness Ra of less than 5 nm , and the mechanically polished first principal surface 10 was bonded to the semiconductor layer 7 (FIG. 8).

When the semiconductor layer 7 is thin, making the semiconductor layer 7 a free-standing object is difficult. Here, use of a supporting substrate is preferable. In Embodiment 4, the semiconductor layer 7 was bonded to a supporting substrate 9 through an adhesive layer 11, and used. Although a silicon substrate was used as the supporting substrate 9 in Embodiment 4, the supporting substrate 9 may be a substrate made of a material such as quartz, silicon carbide, or sapphire, and may be any substrate as long as it withstands temperatures ranging from 800 °C to 1000 °C that are synthesis temperatures of diamond. Furthermore, tetraethoxysilane (TEOS) fabricated in CVD was used as the adhesive layer 11.

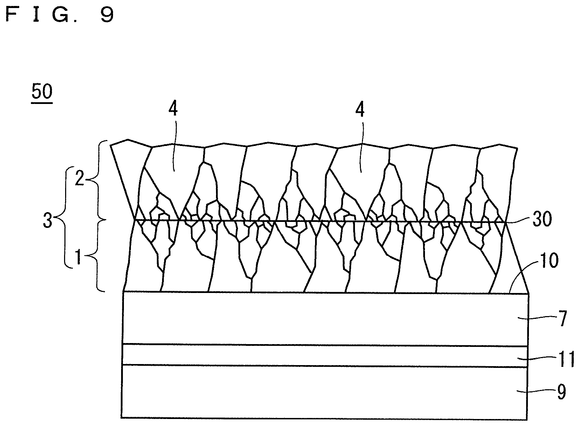

Next, polycrystalline diamond was synthesized on a back side of the first polycrystalline diamond layer 1 in microwave CVD to form the second polycrystalline diamond layer 2 (FIG. 9). Here, the second polycrystalline diamond layer 2 was fabricated under the same conditions as those for the first polycrystalline diamond layer 1 other than the synthesis time. The synthesis time of the second polycrystalline diamond layer 2 will be described later.

Next, the supporting substrate 9 and the adhesive layer 11 were removed. There is no particular restraint on a method for removing the supporting substrate 9 and the adhesive layer 11 as long as the method is suitable for removing these. A physical method such as grinding or polishing should be appropriately combined with a chemical method such as wet etching or dry etching.

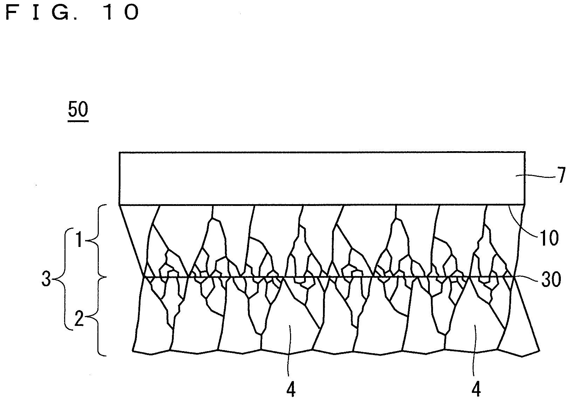

Through these processes, the polycrystalline diamond substrate 3 is completed, and the semiconductor device 50 including the polycrystalline diamond substrate 3 and the semiconductor layer 7 is completed (FIG. 10).

In the method for manufacturing the semiconductor device according to Embodiment 4, the effect of the stress of the first polycrystalline diamond layer 1 that attempts to warp the first polycrystalline diamond layer 1 is offset against the effect of the stress of the second polycrystalline diamond layer 2 that attempts to warp the second polycrystalline diamond layer 2. Thus, adhesion properties of a bonded portion between the polycrystalline diamond substrate 3 and the semiconductor layer 7 are improved, and the bonding strength of the polycrystalline diamond substrate 3 and the semiconductor layer 7 increases. Thus, the polycrystalline diamond substrate 3 is applicable as a heat spreader.

Sometimes, the bonding process warps the semiconductor layer 7, and worsens the characteristics of the semiconductor layer 7. Forming the second polycrystalline diamond layer 2 in the method for manufacturing the semiconductor device according to Embodiment 4 can reduce the warpage of the semiconductor layer 7 caused by the bonding, thus obtaining the semiconductor device 50 with inhibited warpage. Moreover, the worsening of the characteristics of the semiconductor layer 7 can be reduced. Here, the warpage of the first polycrystalline diamond layer 1 and the semiconductor layer 7 that have been bonded together should be evaluated first.

Then, the synthesis time of the second polycrystalline diamond layer 2 should be adjusted so that the second polycrystalline diamond layer 2 can offset the warpage. Besides, the warpage of each of the first polycrystalline diamond layer 1 and the semiconductor layer 7 before and after the bonding should be evaluated first. Then, the synthesis time of the second polycrystalline diamond layer 2 may be adjusted.

Since the second polycrystalline diamond layer 2 is formed in CVD with interposition of the first polycrystalline diamond layer 1, the semiconductor layer 7 is not exposed to plasma even in forming the second polycrystalline diamond layer 2. Thus, the polycrystalline diamond substrate 3 can be formed as a heat spreader while damages to the semiconductor layer 7 are suppressed.

Embodiments can be freely combined, and appropriately modified or omitted.

### EXPLANATION OF REFERENCE SIGNS

- 1: first polycrystalline diamond layer
- 2, 2b: second polycrystalline diamond layer
- 3, 3b: polycrystalline diamond substrate
- 4: diamond crystal grain
- 5: underlying substrate
- 7: semiconductor layer
- 7a: barrier layer
- 7b: channel layer
- 7c: buffer layer
- 8: electrode
- 9: supporting substrate
- 10: first principal surface
- 11: adhesive layer
- 20: second principal surface
- 30: intermediate surface
- 50: semiconductor device
- 70: semiconductor element.

## Claims

1. A method for manufacturing a semiconductor device (50), the method comprising:
- preparing a material (7, 70) with a surface on which a semiconductor layer (7) is exposed;
- forming a first polycrystalline diamond layer (1) on an underlying substrate (5) in CVD;
- removing the underlying substrate (5) from the first polycrystalline diamond layer (1); and
- forming a second polycrystalline diamond layer (2, 2b) on an intermediate surface (30) in CVD, the intermediate surface (30) being a surface of the first polycrystalline diamond layer (1) on which the underlying substrate (5) used to be formed,
wherein an average grain diameter of the intermediate surface (30) is smaller than each of average grain diameters of a first principal surface (10) and a second principal surface (20), the first principal surface (10) being a principal surface of the first polycrystalline diamond layer (1) and opposite to the second polycrystalline diamond layer (2, 2b), the second principal surface (20) being a principal surface of the second polycrystalline diamond layer (2, 2b) and opposite to the first polycrystalline diamond layer (1), and
the surface of the material (7, 70) on which the semiconductor layer (7) is exposed is bonded to the first principal surface (10) before the forming of the second polycrystalline diamond layer (2, 2b).

2. The method according to claim 1,
wherein in the forming of the second polycrystalline diamond layer (2, 2b), a stress of the second polycrystalline diamond layer (2, 2b) is adjusted according to a stress of the first polycrystalline diamond layer (1).

3. The method according to claim 1,
wherein a radius of curvature of each of the second polycrystalline diamond layer (2, 2b) and the first polycrystalline diamond layer (1) after the forming of the second polycrystalline diamond layer (2, 2b) is larger than a radius of curvature of the first polycrystalline diamond layer (1) after the removing and before the forming of the second polycrystalline diamond layer (2, 2b).

4. The method according to one of claims 1 to 3,
wherein the first polycrystalline diamond layer (1) and the second polycrystalline diamond layer (2, 2b) are formed under same conditions in CVD.

5. The method according to one of claims 1 to 3,
wherein a synthetic rate of the second polycrystalline diamond layer (2, 2b) in the forming of the second polycrystalline diamond layer (2, 2b) is higher than a synthetic rate of the first polycrystalline diamond layer (1) in the forming of the first polycrystalline diamond layer (1).

6. The method according to one of claims 1 to 5,
wherein the material (70) is a semiconductor element.

7. The method according to one of claims 1 to 6,
the method comprising:
- polishing off the surface of the first polycrystalline diamond layer (1) on which the underlying substrate (5) used to be formed to remove a growth initial layer, and
- forming the second polycrystalline diamond layer (2, 2b) on the intermediate surface (30) in CVD, the intermediate surface (30) being the surface of the first polycrystalline diamond layer (1) on which the underlying substrate (5) used to be formed and being a surface from which the growth initial layer has been removed by the polishing off.

## Patentansprüche

1. Verfahren zur Herstellung einer Halbleitereinheit (50),
wobei das Verfahren folgende Schritte aufweist:
- Herstellen eines Materials (7, 70) mit einer Oberfläche, auf der eine Halbleiterschicht (7) freiliegt;
- Ausbilden einer ersten polykristallinen Diamantschicht (1) auf einem darunterliegenden Substrat (5) durch CVD;
- Entfernen des darunterliegenden Substrats (5) von der ersten polykristallinen Diamantschicht (1); und
- Ausbilden einer zweiten polykristallinen Diamantschicht (2, 2b) auf einer Zwischenoberfläche (30) durch CVD, wobei die Zwischenoberfläche (30) eine Oberfläche der ersten polykristallinen Diamantschicht (1) ist, auf der das darunterliegende Substrat (5) ausgebildet war,
wobei ein durchschnittlicher Korndurchmesser der Zwischenfläche (30) kleiner ist als jeder der durchschnittlichen Korndurchmesser einer ersten Hauptoberfläche (10) und einer zweiten Hauptoberfläche (20), wobei die erste Hauptoberfläche (10) eine Hauptoberfläche der ersten polykristallinen Diamantschicht (1) ist und der zweiten polykristallinen Diamantschicht (2, 2b) gegenüberliegt, wobei die zweite Hauptoberfläche (20) eine Hauptoberfläche der zweiten polykristallinen Diamantschicht (2, 2b) ist und der ersten polykristallinen Diamantschicht (1) gegenüberliegt, und
die Oberfläche des Materials (7, 70), auf der die Halbleiterschicht (7) freiliegt, vor der Bildung der zweiten polykristallinen Diamantschicht (2, 2b) mit der ersten Hauptoberfläche (10) verbunden wird.

2. Verfahren nach Anspruch 1,
wobei bei der Bildung der zweiten polykristallinen Diamantschicht (2, 2b) eine Spannung der zweiten polykristallinen Diamantschicht (2, 2b) in Abhängigkeit von einer Spannung der ersten polykristallinen Diamantschicht (1) eingestellt wird.

3. Verfahren nach Anspruch 1,
wobei ein Krümmungsradius der zweiten polykristallinen Diamantschicht (2, 2b) und der ersten polykristallinen Diamantschicht (1) nach der Bildung der zweiten polykristallinen Diamantschicht (2, 2b) größer ist als ein Krümmungsradius der ersten polykristallinen Diamantschicht (1) nach dem Entfernen und vor dem Ausbilden der zweiten polykristallinen Diamantschicht (2, 2b).

4. Verfahren nach einem der Ansprüche 1 bis 3,
wobei die erste polykristalline Diamantschicht (1) und die zweite polykristalline Diamantschicht (2, 2b) unter gleichen Bedingungen durch CVD gebildet werden.

5. Verfahren nach einem der Ansprüche 1 bis 3,
wobei die Syntheserate der zweiten polykristallinen Diamantschicht (2, 2b) bei der Bildung der zweiten polykristallinen Diamantschicht (2, 2b) höher ist als die Syntheserate der ersten polykristallinen Diamantschicht (1) bei der Bildung der ersten polykristallinen Diamantschicht (1).

6. Verfahren nach einem der Ansprüche 1 bis 5,
wobei das Material (70) ein Halbleiterelement ist.

7. Verfahren nach einem der Ansprüche 1 bis 6,
wobei das Verfahren Folgendes aufweist:
- Polieren der Oberfläche der ersten polykristallinen Diamantschicht (1), auf der das darunterliegende Substrat (5) gebildet worden ist, um eine anfängliche Wachstumsschicht zu entfernen, und
- Ausbilden der zweiten polykristallinen Diamantschicht (2, 2b) auf der Zwischenoberfläche (30) durch CVD, wobei die Zwischenoberfläche (30) die Oberfläche der ersten polykristallinen Diamantschicht (1) ist, auf der das darunterliegende Substrat (5) ausgebildet worden ist, und eine Oberfläche ist, von der die anfängliche Wachstumsschicht durch das Polieren entfernt worden ist.

## Revendications

1. Procédé de fabrication d'un dispositif semi-conducteur (50), le procédé comprenant les étapes consistant à :
- préparer un matériau (7, 70) avec une surface sur laquelle est exposée une couche semi-conductrice (7) ;
- former une première couche de diamant polycristallin (1) sur un substrat sous-jacent (5) par dépôt chimique en phase vapeur (CVD) ;
- éliminer le substrat sous-jacent (5) de la première couche de diamant polycristallin (1) ; et
- former une deuxième couche de diamant polycristallin (2, 2b) sur une surface intermédiaire (30) par CVD, la surface intermédiaire (30) étant une surface de la première couche de diamant polycristallin (1) sur laquelle a été formé le substrat sous-jacent (5),
dans lequel un diamètre de grain moyen de la surface intermédiaire (30) est inférieur à chacun des diamètres de grain moyens d'une première surface principale (10) et d'une deuxième surface principale (20), la première surface principale (10) étant une surface principale de la première couche de diamant polycristallin (1) et opposée à la deuxième couche de diamant polycristallin (2, 2b), la deuxième surface principale (20) étant une surface principale de la deuxième couche de diamant polycristallin (2, 2b) et opposée à la première couche de diamant polycristallin (1), et
la surface du matériau (7, 70) sur laquelle est exposée la couche semi-conductrice (7) est liée à la première surface principale (10) avant l'étape de formation de la deuxième couche de diamant polycristallin (2, 2b).

2. Procédé selon la revendication 1,
dans lequel, dans l'étape de formation de la deuxième couche de diamant polycristallin (2, 2b), une contrainte de la deuxième couche de diamant polycristallin (2, 2b) est ajustée en fonction d'une contrainte de la première couche de diamant polycristallin (1).

3. Procédé selon la revendication 1,
dans lequel un rayon de courbure de chacune de la deuxième couche de diamant polycristallin (2, 2b) et de la première couche de diamant polycristallin (1) après l'étape de formation de la deuxième couche de diamant polycristallin (2, 2b) est supérieur à un rayon de courbure de la première couche de diamant polycristallin (1) après l'étape d'élimination et avant l'étape de formation de la deuxième couche de diamant polycristallin (2, 2b).

4. Procédé selon l'une des revendications 1 à 3,
dans lequel la première couche de diamant polycristallin (1) et la deuxième couche de diamant polycristallin (2, 2b) sont formées dans les mêmes conditions par CVD.

5. Procédé selon l'une des revendications 1 à 3,
dans lequel un taux synthétique de la deuxième couche de diamant polycristallin (2, 2b) à l'étape de formation de la deuxième couche de diamant polycristallin (2, 2b) est plus élevé qu'un taux synthétique de la première couche de diamant polycristallin (1) à l'étape de formation de la première couche de diamant polycristallin (1).

6. Procédé selon l'une des revendications 1 à 5,
dans lequel le matériau (70) est un élément semi-conducteur.

7. Procédé selon l'une des revendications 1 à 6,
le procédé comprenant les étapes consistant à :
- polir la surface de la première couche de diamant polycristallin (1) sur laquelle a été formé le substrat sous-jacent (5) pour éliminer une couche initiale de croissance, et
- former la deuxième couche de diamant polycristallin (2, 2b) sur la surface intermédiaire (30) par CVD, la surface intermédiaire (30) étant la surface de la première couche de diamant polycristallin (1) sur laquelle a été formé le substrat sous-jacent (5), et étant une surface à partir de laquelle la couche initiale de croissance a été éliminée par le polissage.
